# EUROPÄISCHE PATENTSCHRIFT

(11) **EP 4 336 576 B1**
(45) Veröffentlichungstag und Bekanntmachung des Hinweises auf die Patenterteilung: **30.04.2025**
(21) Anmeldenummer: 22194828.4
(22) Anmeldetag: 09.09.2022
(51) Int. Cl.: H10H 20/858, H05K 1/02

(54) **LEUCHTMITTEL FÜR EINEN KRAFTFAHRZEUGSCHEINWERFER**
LIGHTING MEANS FOR A MOTOR VEHICLE HEADLIGHT
MOYEN D'ÉCLAIRAGE POUR UN PHARE DE VÉHICULE AUTOMOBILE

(43) Veröffentlichungstag der Anmeldung: 13.03.2024
(73) Patentinhaber: ZKW Group GmbH, 3250 Wieselburg (AT)
(72) Erfinder: Mayerhofer, Markus, 2880 Otterthal (AT); Emmerich, Albrecht, 1150 Wien (AT)
(74) Vertreter: Patentanwaltskanzlei Matschnig & Forsthuber OG

(56) Entgegenhaltungen:
- CN-A- 109 273 423
- US-A1- 2013 087 813
- HERRON DERRICK ET AL: "Effective voiding control of QFN via solder mask patterning", PROCEEDINGS OF THE 27 TH ELECTRONIC COMPONENTS CONFERENCE (7TH ELECTRONIC COMPONENTS CONFERENCE, STOUFFER'S NATIONAL CENTER INN, ARLINGTON, VA., MAY 16-18, 1977), INSTITUTE OF ELECTRICAL AND ELECTRONICS ENGINEERS, 28 May 2013 (2013-05-28), pages 468 - 474, XP032473957, ISSN: 0569-5503, [retrieved on 20130806], DOI: 10.1109/ECTC.2013.6575613

## Beschreibung

Die Erfindung betrifft ein Leuchtmittel für einen Kraftfahrzeugscheinwerfer, wobei das Leuchtmittel Folgendes umfasst:
* ein SMD-Bauteil, umfassend eine Lichtquelle zur Erzeugung von Licht, wobei das SMD-Bauteil eine lichtemittierende Oberseite, an welcher die Lichtquelle angeordnet ist, und eine der lichtemittierenden Oberseite abgewandte Unterseite aufweist, und
* einen Schaltungsträger, wobei das SMD-Bauteil an einem Bestückungsabschnitt des Schaltungsträgers mit dem Schaltungsträger mittels einer Lötverbindung wärmeleitend und/oder elektrisch leitend verbunden ist, wobei die Lötverbindung eine Lötschicht umfasst, welche Lötgut aufweist, wobei die Lötschicht zwischen der Unterseite des SMD-Bauteils und dem Bestückungsabschnitt des Schaltungsträgers angeordnet ist und das SMD-Bauteil mit dem Schaltungsträger verbindet, wobei

der Bestückungsabschnitt des Schaltungsträgers eine Vielzahl von in einem Raster angeordneten und zueinander beabstandeten Kontakt-Elementen aufweist, welche sich von einer, vorzugsweise ebenen, Grundfläche des Schaltungsträgers in Richtung des SMD-Bauteils erstrecken und eine dem SMD-Bauteil abgewandte Seite der Lötschicht kontaktieren, wobei zwischen benachbarten Kontakt-Elementen Gasaustrittskanal-Abschnitte gebildet sind, wobei die Kontakt-Elemente derart zueinander angeordnet sind, dass die Gasaustrittskanal-Abschnitte ein zusammenhängendes Gasaustrittskanal-System ausbilden, sodass jedes Kontakt-Element von einem Abschnitt des zusammenhängenden Gasaustrittskanal-Systems umrandet ist, wobei die Gasaustrittskanal-Abschnitte von Seitenflächen benachbarter Kontakt-Elemente, der Grundfläche und der dem SMD-Bauteil abgewandten Seite der Lötschicht begrenzt sind, wobei das Gasaustrittskanal-System derart ausgestaltet und dazu eingerichtet ist, Gase, welche beim Lötprozess aus der Lötschicht entweichen, über das Gasaustrittskanal-System aus einem zwischen der Lötschicht und der Grundfläche des Schaltungsträgers ausgebildeten Volumen entweichen zu lassen,
wobei zur Wärmeabfuhr von Abwärme des SMD-Bauteils der Schaltungsträger eine Vielzahl von zur Wärmeleitung eingerichtete Mikro-Vias aufweist, wobei die Wärmeleitung im Wesentlichen entlang einer Längserstreckung der Mikro-Vias erfolgt, wobei die Mikro-Vias in dem Schaltungsträger derart angeordnet sind, dass sich die Mikro-Vias zumindest abschnittsweise durch den Schaltungsträger hin zum Bestückungsabschnitt erstrecken und die Vielzahl von Kontakt-Elementen durchsetzen, sodass die Mikro-Vias die Lötschicht an einem Kontaktbereich der Lötschicht zur Wärmeabfuhr kontaktieren, wobei die Mikro-Vias an dem Kontaktbereich einen im Wesentlichen kreisförmigen Querschnitt aufweisen.

Die Erfindung betrifft ferner einen Kraftfahrzeugscheinwerfer, umfassend ein Leuchtmittel.

Im Stand der Technik sind Leuchtmittel für Kraftfahrzeugscheinwerfer bekannt, wobei derartige Leuchtmittel häufig ein SMD-Bauteil mit einer Lichtquelle aufweisen, und das SMD-Bauteil an einem Schaltungsträger befestigt ist. Der Schaltungsträger ist in der Regel unter anderem auch zur Kühlung des SMD-Bauteils (bzw. der Lichtquelle) eingerichtet, wobei dies im Stand der Technik häufig über so genannte Mikro-Vias erfolgt, welche sich zumindest teilweise durch den Schaltungsträger (bzw. von einem inneren Bereich des Schaltungsträgers) hin zum SMD-Bauteil erstrecken. Üblicherweise wird das SMD-Bauteil mit dem Schaltungsträger verlötet, wobei sich vor allem bei Lötverbindungen mit großflächigen Lötschichten (bzw. Lotschichten; also eine Schicht, welche (nach dem Lötvorgang) erstarrtes Lot bzw. Lotmaterial aufweist, um eine stoffschlüssige Verbindung zwischen Komponenten herzustellen) Hohlräume in der Lötschicht ausbilden können. Die Hohlräume bilden sich durch Gase, welche während dem Lötprozess (bzw. während der Verflüssigung des beim Lötprozess verwendeten Lötguts) entstehen. Durch die Hohlräume verringert sich die effektive Kontaktfläche zwischen dem SMD-Bauteil und dem Schaltungsträger. Um die Ausbildung der Hohlräume zu reduzieren, muss sichergestellt sein, dass die Gase aus der Lötschicht entweichen können, wobei üblicherweise zwischen der Lötschicht und dem Schaltungsträger entsprechende Gasaustrittskanäle ausgebildet werden. Durch derartige Gasaustrittskanäle wird die effektive Kontaktfläche zwischen der Lötschicht und dem Schaltungsträger reduziert, wodurch die Kühlung verschlechtert wird. Die im Stand der Technik bekannten Lösungen müssen somit einen Kompromiss zwischen effektiver Kühlung (hohe Anzahl an Mikro-Vias) und effektivem Gasaustritt (hohe Anzahl an Gasaustrittskanälen) eingehen.

Die Aufgabe der vorliegenden Erfindung besteht darin, die Nachteile des Standes der Technik zu lindern bzw. zu beseitigen. Die Erfindung setzt sich daher insbesondere zum Ziel, ein Leuchtmittel zu schaffen, bei welchem die Lötverbindung zwischen Komponenten des Leuchtmittels verbessert wird.

Diese Aufgabe wird durch ein Leuchtmittel mit den Merkmalen von Anspruch 1 gelöst. Bevorzugte Ausführungen sind in den abhängigen Ansprüchen angegeben.

Erfindungsgemäß weisen eine Anzahl von Kontakt-Elementen eine im Wesentlichen hexagonale Grundfläche auf, wobei die Grundflächen in einer Ebene liegen, welche im Wesentlichen parallel zur Grundfläche des Schaltungsträgers, und vorzugsweise parallel zur Unterseite des SMD-Bauteils, orientiert ist, wobei

die Mikro-Vias in einer zweidimensionalen hexagonalen Packungsanordnung derart zueinander angeordnet sind, dass die im Wesentlichen hexagonalen Grundflächen der Kontakt-Elemente von einer Vielzahl von Mikro-Vias im Wesentlichen vollständig, gemäß der höchsten Flächenpackungsdichte, durchsetzt sind.

Dadurch kann vorteilhafterweise die Anzahl an Mikro-Vias pro Kontakt-Elementfläche maximiert werden, was wiederum die Kühlung des SMD-Bauteils verbessert. Gleichzeitig können Gase durch das Gasaustrittskanal-System aus dem während dem Lötprozess verflüssigten Lötgut, während der Herstellung einer festen (bzw. starren) Lötschicht, entweichen. Die Lötschicht kann somit insbesondere im Wesentlichen gasblasenfrei ausgestaltet sein. Als hexagonale Grundfläche wird in diesem Zusammenhang ein Polygon mit sechs Ecken und sechs Seiten verstanden. Bevorzugt bilden die Grundflächen der Anzahl an Kontakt-Elementen ein gleichseitiges Sechseck (Hexagon) aus (alle sechs Seiten sind gleich lang), besonders bevorzugt bilden die Grundflächen der Anzahl an Kontakt-Elementen ein reguläres oder regelmäßiges Sechseck (alle sechs Seiten sind gleich lang und darüber hinaus sind alle Winkel an den sechs Ecken gleich groß). Die Anzahl an Kontakt-Elementen mit einer im Wesentlichen hexagonalen Grundfläche kann alle Kontakt-Elemente umfassen oder weniger, beispielsweise zumindest 90%, 80%, 70%, 60% oder 50% aller Kontakt-Elemente der Gesamtanzahl an Kontakt-Elementen. Je höher die Anzahl an Kontakt-Elementen mit einer im Wesentlichen hexagonale Grundfläche desto effizienter kann die Kühlung des SMD-Bauteils erfolgen, da die im Wesentlichen hexagonale Grundfläche gemäß der höchsten Packungsdichte mit Mikro-Vias durchsetzt werden kann. Die Mikro-Vias (bevorzugt der wärmeleitende (Metall-)Kern der Mikro-Vias) können insbesondere ausgehend von einem Innenbereich des Schaltungsträger (beispielsweise ein Metall-Inlay) an der Lötschicht münden bzw. diese zur Wärmeleitung kontaktieren. Die Lichtquelle kann eine Pixel-LED Lichtquelle umfassen. Die Lötverbindung kann mit einem Lötprozess hegestellt sein, welcher bevorzugt ein Reflow Lötprozess ist.

Es kann vorgesehen sein, dass benachbarte Mikro-Vias an der hexagonalen Grundfläche eines Kontakt-Elements im Wesentlichen unmittelbar aneinander angrenzend zueinander angeordnet sind, wobei vorzugsweise die Vielzahl von Mikro-Vias an dem Kontaktbereich einen im Wesentlichen gleich großen Durchmesser aufweisen. Unter Kontaktbereich ist jener Bereich zu verstehen an dem die Mikro-Vias, bzw. das Kontakt-Element die Lötschicht kontaktierten.

Es kann vorgesehen sein, dass die Mikro-Vias an dem Kontaktbereich einen Lochinnendurchmesser aufweisen, welcher vorzugsweise < 0,5 mm, bevorzugt < 0,25 mm, besonders bevorzugt < 0,15 mm, beträgt. Bevorzugt weisen die Mikro-Vias einen Durchmesser von 0,1 bis 0,2 mm auf. Bevorzugt ist der Abstand zwischen benachbarten Mikro-Vias 0,1 bis 0,35 mm.

Es kann vorgesehen sein, dass die Mikro-Vias entlang ihrer Längserstreckung im Wesentlichen kegelförmig oder kegelstumpfförmig ausgestaltet sind, wobei vorzugsweise die Mikro-Vias derart ausgestaltet sind, dass sich ein Kegeldurchmesser oder ein Kegelstumpfdurchmesser zur Lötschicht hin verkleinert, wobei insbesondere ein Winkel zwischen einer Kegelachse oder einer Kegelstumpfachse und einer Mantelfläche des Kegels oder des Kegelstumpfs 6° bis 15° beträgt.

Es kann vorgesehen sein, dass die Mikro-Vias in dem Schaltungsträger derart angeordnet sind, dass jene Bereiche des Bestückungsabschnitts, welche das Gasaustrittskanal-System aufweisen, frei von Mikro-Vias sind. Insbesondere sind ausschließlich die Kontakt-Elemente mit Mikro-Vias durchsetzt.

Es kann vorgesehen sein, dass der Schaltungsträger eine dem SMD-Bauteil zugewandte Außenfläche aufweist, an welcher der Bestückungsabschnitt ausgebildet ist, wobei der Schaltungsträger eine Lötstopplackschicht aufweist, welche zumindest teilweise,
vorzugsweise vollständig, um den Bestückungsabschnitt herum an der Außenfläche angeordnet ist.

Es kann vorgesehen sein, dass die Kontakt-Elemente mit einem wärmeleitenden und/oder elektrisch leitenden Material, insbesondere mit einem Metall, beispielsweise Kupfer, beschichtet sind oder aus einem wärmeleitenden und/oder elektrisch leitenden Material ausgebildet sind.

Es kann vorgesehen sein, dass der Schaltungsträger als eine mehrschichtige Leiterplatte ausgestaltet ist, welche ein Metall-Inlay, vorzugsweise ein Kupfer-Inlay, aufweist, wobei die Mirco-Vias mit dem Metall-Inlay wärmeleitend verbunden sind. Vorzugsweise sind die Mikro-Vias mit Metall, insbesondere Kupfer, gefüllt und über diese Metallfüllung mit dem Metall-Inlay wärmeleitend verbunden. Vorzugsweise ist das wärmeleitende Füllmaterial der Mikro-Vias das gleiche Material wie das Metall-Inlay des Schaltungsträgers.

Es kann vorgesehen sein, dass die hexagonalen Kontakt-Elemente Polyeder ausbilden, welche eine im Wesentlichen gleich große hexagonale Grundfläche aufweisen. Das Gasaustrittskanal-System ist insbesondere zwischen den Polyedern ausgebildet. Die Kontakt-Elemente können insbesondere eine erste Anzahl an Rand-Elementen und eine zweite Anzahl an Zentral-Elementen aufweisen, wobei die Rand-Elemente am Rand des Bestückungsabschnitts angeordnet sind und wobei die Zentral-Elemente von den Rand-Elementen umgeben sind. Vorzugsweise weisen zumindest die Zentral-Elemente, vorzugsweise auch die Rand-Elemente, eine hexagonale Grundfläche auf.

Es kann vorgesehen sein, dass die Grundflächen der hexagonalen Kontakt-Elemente jeweils ein regelmäßiges Hexagon ausbilden.

Es kann vorgesehen sein, dass jeder Gasaustrittskanal-Abschnitt des Gasaustrittskanal-Systems eine Kanalbreite aufweist, welche als ein Normalabstand zwischen parallelen Seitenkanten von zwei benachbarten Kontakt-Elementen definiert ist, wobei das Gasaustrittskanal-System derart ausgestaltet ist, dass alle Gasaustrittskanal-Abschnitte im Wesentlichen die gleiche Kanalbreite aufweisen. Die Kanalbreite eines Gasaustrittskanal-Abschnitts ist bevorzugt 150-250 µm.

Es kann vorgesehen sein, dass jeder Gasaustrittskanal-Abschnitt des Gasaustrittskanal-Systems eine Kanalhöhe aufweist, welche einem Normalabstand zwischen der Grundfläche des Schaltungsträgers und der dem SMD-Bauteil abgewandten Seite der Lötschicht entspricht, wobei vorzugsweise die Kanalhöhe des Gasaustrittskanal-Systems über den gesamten Bestückungsabschnitt konstant ist, wobei vorzugsweise die Kanalhöhe 100-200 µm beträgt. Die Kanalhöhe kann insbesondere der vertikalen Höhe der Kontakt-Elemente entsprechen (vorzugsweise die vertikale Höhe der Kontakt-Elemente zwischen der Grundfläche und der Lötschicht). Die Kanalhöhe kann somit als Schichtdicke der Kontakt-Elemente verstanden werden.

Es kann vorgesehen sein, dass der Bestückungsabschnitt des Schaltungsträgers eine größere Fläche aufweist als die Unterseite des SMD-Bauteils. Der Bestückungsabschnitt ist bevorzugt ein auf dem Schaltungsträger ausgebildeter Bereich (bzw. Flächenabschnitt), welcher mit Lötgut benetzbar ist und welcher zur Aufnahme, und in weiterer Folge zur elektrischen, thermischen bzw. mechanischen Kontaktierung, eines SMD-Bauteils ausgestaltet ist.

Es kann vorgesehen sein, dass die Verbindung zwischen dem SMD-Bauteil und dem Bestückungsabschnitt des Schaltungsträgers durch die Lötschicht derart ausgestaltet ist, dass die Unterseite des SMD-Bauteils, die Grundfläche des Schaltungsträgers und die Grundflächen der hexagonalen Kontakt-Elemente in Ebenen liegen, welche im Wesentlichen parallel zu einander orientiert sind.

Es kann vorgesehen sein, dass von der Vielzahl von in einem Raster angeordneten Kontakt-Elementen zumindest 50%, vorzugsweise mehr als 75%, bevorzugt mehr als 85%, besonders bevorzugt mehr als 95% der Kontakt-Elemente eine hexagonale Grundfläche aufweisen.

Es kann ein Kraftfahrzeugscheinwerfer vorgesehen sein, welcher ein erfindungsgemäßes Leuchtmittel aufweist.

US 2013/087813 A1 offenbart ein Leuchtmittel gemäß dem Stand der Technik.

Die Erfindung ist im Folgenden anhand eines beispielhaften und nicht einschränkenden Ausführungsbeispiels näher erläutert, das in den Figuren veranschaulicht ist. Darin zeigt
Figur 1 eine schematische Schnittansicht eines erfindungsgemäßen Leuchtmittels;
Figur 2 eine schematische Darstellung eines Schaltungsträgers gemäß eines ersten Ausführungsbeispiels eines erfindungsgemäßen Leuchtmittels;
Figur 3 eine schematische Darstellung eines Schaltungsträgers gemäß eines zweiten Ausführungsbeispiels eines erfindungsgemäßen Leuchtmittels;

In den folgenden Figuren bezeichnen - sofern nicht anders angegeben - gleiche Bezugszeichen gleiche Merkmale.

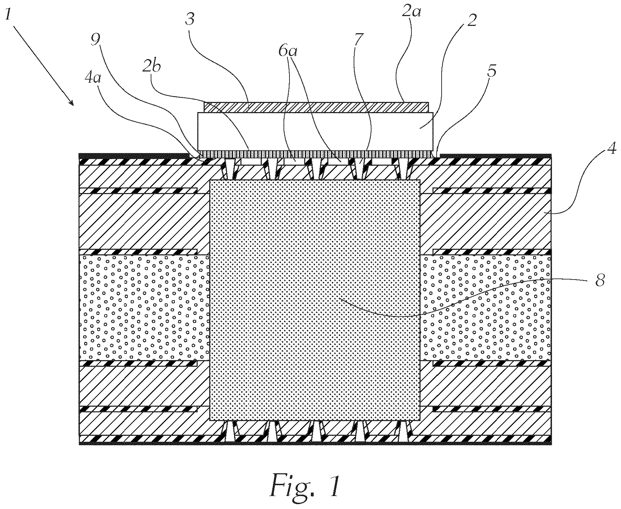

**Figur 1** zeigt eine schematische Schnittansicht eines erfindungsgemäßen Leuchtmittels 1 für einen Kraftfahrzeugscheinwerfer. Das Leuchtmittel 1 umfasst ein SMD-Bauteil 2 mit einer Lichtquelle 3 zur Erzeugung von Licht. Das SMD-Bauteil 2 hat eine Oberseite 2a, an welcher die Lichtquelle 3 angeordnet ist, wodurch die Oberseite 2a lichtemittierend ausgebildet ist. Das SMD-Bauteil 2 hat ferner eine der lichtemittierenden Oberseite 2a abgewandte Unterseite 2b. Die Lichtquelle 3 kann eine Pixel-LED Lichtquelle sein.

Das Leuchtmittel 1 umfasst einen Schaltungsträger 4, wobei das SMD-Bauteil 2 mit dem Schaltungsträger 4 mittels einer Lötverbindung wärmeleitend und elektrisch leitend verbunden ist. Die Lötverbindung ist als Lötschicht 9 ausgebildet, welche Lötgut aufweist. Das grundlegende Prinzip zur Herstellung einer derartigen Lötverbindung ist einem Fachmann bekannt, weshalb hier nicht näher darauf eingegangen wird. Die Lötschicht 9 ist zwischen der Unterseite 2b des SMD-Bauteils 2 und einem Bestückungsabschnitt 4a des Schaltungsträgers 4 angeordnet und verbindet das SMD-Bauteil 2 mit dem Schaltungsträger 4. Die Lötverbindung wird durch einen Lötprozess hergestellt. Der Lötprozess kann ein Reflow Lötprozess sein. Um einen gleichmäßigen Auftrag (bzw. eine gleichmäßige Schichtdicke) von Lötgut zu ermöglichen, kann es, insbesondere bei großflächigen Lötverbindungen (bzw. Bestückungsabschnitten 4a), vorteilhaft sein das Lötgut (im Zuge des Lötprozesses) nicht durchgehend aufzutragen, sondern das Lötgut mittels einer Schablone in Lötgut-Segmente zu unterteilen. Die daraus resultierende (nach deren Herstellungsprozess ausgehärtete) Lötschicht 9 ist (insbesondere im Wesentlichen über den gesamten Bestückungsabschnitt 4a) durchgehend ausgebildet.

Der Schaltungsträger 4 ist in dem in Figur 1 gezeigten Ausführungsbeispiel als eine mehrschichtige Leiterplatte ausgestaltet, welche ein Metall-Inlay 8, vorzugsweise ein Kupfer-Inlay, aufweist. Die Mirco-Vias 7 sind mit dem Metall-Inlay 8 wärmeleitend verbunden. Die Mirco-Vias 7 sind insbesondere mit Metall, vorzugsweise Kupfer, gefüllt und mit dem Metall-Inlay 8 verbunden.

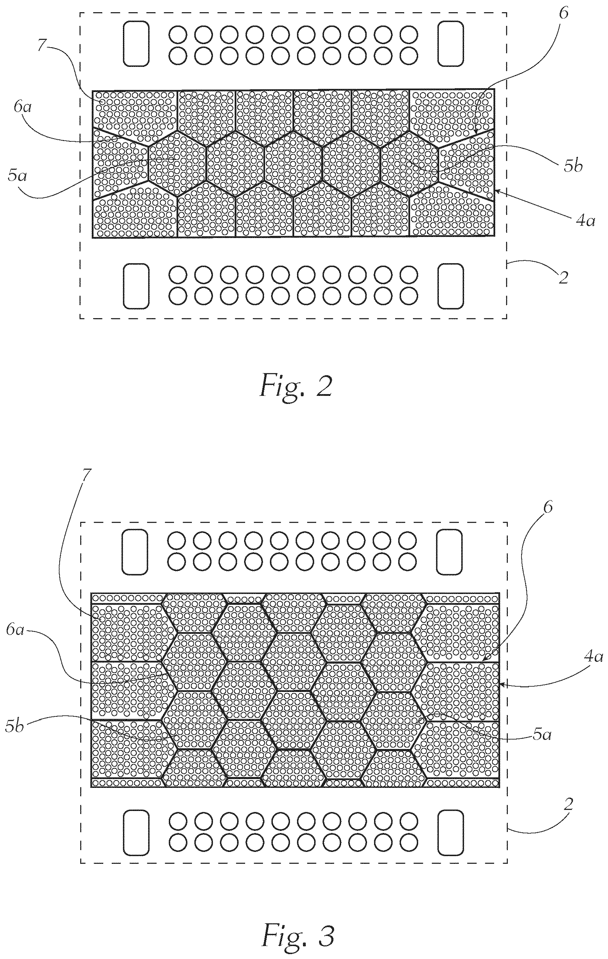

Wie in **Figur 2** und **Figur 3** ersichtlich, ist der Bestückungsabschnitt 4a aus einer Vielzahl von in einem Raster angeordneten und zueinander beabstandeten Kontakt-Elementen 5a gebildet, welche ein Kontakt-Elementraster 5 formen. Zwischen benachbarten Kontakt-Elementen 5a sind Gasaustrittskanal-Abschnitte 6a gebildet. Die Kontakt-Elemente 5a sind derart zueinander angeordnet, dass die Gasaustrittskanal-Abschnitte 6a ein zusammenhängendes Gasaustrittskanal-System 6 durch den (bzw. in dem) Bestückungsabschnitt 4a ausbilden. Jedes Kontakt-Element 5a ist von einem Abschnitt des zusammenhängenden Gasaustrittskanal-Systems 6 umrandet. Das Gasaustrittskanal-System 6 ist derart ausgestaltet und dazu eingerichtet, Gase, welche beim Lötprozess aus dem verflüssigtem Lotvolumen, welches sich nach dem Erkalten zur Lötschicht 9 ausbildet, über das Gasaustrittskanal-System 6 aus einem zwischen der Unterseite 2b des SMD-Bauteils 2 und dem Bestückungsabschnitt 4a des Schaltungsträgers 4 ausgebildeten Volumen entweichen zu lassen.

Mit anderen Worten unterteilt das Gasaustrittskanal-System 6 den Bestückungsabschnitt 4a in durch Gasaustrittskanal-Abschnitte 6a voneinander getrennte Teilbereiche, wobei das Gasaustrittskanal-System 6 derart in dem Bestückungsabschnitt 4a ausgestaltet ist, dass die Teilbereiche (bzw. Kontakt-Elemente 5a) des Bestückungsabschnitts 4a einen hexagonalen Grundriss aufweisen. Der Bestückungsabschnitt 4a ist somit durch das den Bestückungsabschnitts 4a durchdringende Gasaustrittskanal-System 6 als segmentierter Bestückungsabschnitts 4a ausgebildet, wobei die einzelnen Segmente als hexagonale Kontakt-Elemente 5a (bzw. Kontakt-Elemente 5a mit hexagonaler Grundfläche) ausgestaltet sind.

Zur Wärmeabfuhr von Abwärme des SMD-Bauteils 2 weist der Schaltungsträger 4 eine Vielzahl von zur Wärmeleitung eingerichteten Mikro-Vias 7 auf, welche einen im Wesentlichen kreisförmigen Querschnitt und eine Längserstreckung aufweisen. Die Wärmeleitung erfolgt im Wesentlichen entlang der Längserstreckung der Mikro-Vias. Die Mikro-Vias 7 sind in dem Schaltungsträger 4 derart angeordnet, dass sich die Mikro-Vias 7 zumindest abschnittsweise durch den Schaltungsträger 4 hin zum Bestückungsabschnitt 4a erstrecken und diesen zumindest abschnittsweise durchsetzen bzw. an der Lötschicht 9 münden. Dadurch durchsetzen die Mikro-Vias 7 den Bestückungsabschnitt 4a an einem Kontaktbereich der Lötschicht 9 zur Wärmeabfuhr. Der Kontaktbereich ist insbesondere ausschließlich an den Kontakt-Elementen 5a des Bestückungsabschnitts 4a ausgebildet.

Wie in den Figuren 2 und 3 gezeigt, weist eine Anzahl von Kontakt-Elementen 5a eine im Wesentlichen hexagonale Grundfläche 5b auf. Die Grundflächen 5b liegen in einer Ebene, welche im Wesentlichen parallel zur Unterseite 2b des SMD-Bauteils 2 orientiert ist.

Die Mikro-Vias 7 sind in einer zweidimensionalen hexagonalen Packungsanordnung derart zueinander angeordnet, dass die im Wesentlichen hexagonalen Grundflächen 5b der Kontakt-Elemente 5a von einer Vielzahl von Mikro-Vias 7 im Wesentlichen vollständig, gemäß der höchsten Flächenpackungsdichte, durchsetzt sind, wobei vorzugsweise ein Minimalabstand zwischen benachbarten Mikro-Vias 7 vorhanden ist. Die hexagonale Grundfläche 5b der Anzahl an Kontakt-Elementen 5a wird somit im Wesentlichen mit den Mikro-Vias 7, welche eine im Wesentlichen kreisförmige Grundfläche aufweisen, aufgefüllt. Benachbarte Mikro-Vias 7 sind innerhalb der hexagonalen Grundfläche 5b der Kontakt-Elemente 5a im Wesentlichen unmittelbar aneinander angrenzend zueinander angeordnet. Die Vielzahl von Mikro-Vias 7 können einen im Wesentlichen gleich großen Durchmesser aufweisen. Die Mikro-Vias 7 haben an dem Kontaktbereich der Lötschicht 9 einen, insbesondere maximalen, Lochinnendurchmesser d, welcher vorzugsweise < 0,5 mm, bevorzugt < 0,25 mm, besonders bevorzugt < 0,15 mm, beträgt. Die Mikro-Vias 7 sind in dem Bestückungsabschnitt 4a des Schaltungsträgers 4 derart angeordnet, dass jene Bereiche des Bestückungsabschnitts 4a, welche das Gasaustrittskanal-System 6 aufweisen, frei von Mikro-Vias 7 sind.

Die hexagonalen Kontakt-Elemente 5a weisen jeweils eine im Wesentlichen gleich große hexagonale Grundfläche 5b auf. Die Grundflächen 5b der hexagonalen Kontakt-Elemente 5a bilden jeweils ein regelmäßiges Hexagon aus.

In dem in Figur 2 gezeigten Ausführungsbeispiel hat die Kontakt-Elementfläche fünf zentrale hexagonale Kontakt-Elemente 5a. Diese sind umrandet von weiteren Kontakt-Elementen, welche andere Formen (weiterer Polygone) aufweisen und ebenfalls von Mikro-Vias 7 durchsetzt sind. Um den Bestückungsabschnitt 4a ist das SMD-Bauteil 2 schematisch angedeutet.

In dem in Figur 3 gezeigten Ausführungsbeispiel hat der Bestückungsabschnitt 4a zwölf zentrale hexagonale Kontakt-Elemente 5a. Diese sind umrandet von weiteren Kontakt-Elementen, welche andere Formen (weiterer Polygone) aufweisen und ebenfalls von Mikro-Vias 7 durchsetzt sind. Um den Bestückungsabschnitt 4a ist wieder das SMD-Bauteil 2 schematisch angedeutet.

Die Anzahl an hexagonalen Kontakt-Elementen 5a ist im Wesentlichen durch deren Größe und die Größe und Form des Bestückungsabschnitts 4a vorgegeben.

Jeder Gasaustrittskanal-Abschnitt 6a des Gasaustrittskanal-Systems 6 weist eine Kanalbreite auf, welche als ein Normalabstand zwischen parallelen Seitenkanten von zwei benachbarten Kontakt-Elementen 5a definiert ist. Das Gasaustrittskanal-System 6 ist bevorzugt derart ausgestaltet, dass alle Gasaustrittskanal-Abschnitte 6a die gleiche Kanalbreite aufweisen.

Jeder Gasaustrittskanal-Abschnitt 6a des Gasaustrittskanal-Systems 6 hat eine Kanalhöhe, welche einem Normalabstand zwischen der Grundfläche 4b des Schaltungsträgers 4 und der dem SMD-Bauteil 2 abgewandten Seite der Lötschicht 9 entspricht. Vorzugsweise ist die Kanalhöhe des Gasaustrittskanal-Systems 6 über den gesamten Bestückungsabschnitt 4a konstant, wobei vorzugsweise die Kanalhöhe 100-200 µm beträgt.

Von der Gesamtzahl von in einem Raster angeordneten Kontakt-Elementen 5a haben zumindest 50%, vorzugsweise mehr als 75%, bevorzugt mehr als 85%, besonders bevorzugt mehr als 95% eine hexagonale Grundfläche 5b.

Die Erfindung ist nicht auf die gezeigten Ausführungsformen beschränkt, sondern durch den gesamten Schutzumfang der Ansprüche definiert.

Etwaige Bezugszeichen in den Ansprüchen sind beispielhaft und dienen nur der einfacheren Lesbarkeit der Ansprüche, ohne diese einzuschränken.

## Patentansprüche

1. Leuchtmittel (1) für einen Kraftfahrzeugscheinwerfer, wobei das Leuchtmittel (1) Folgendes umfasst:
* ein SMD-Bauteil (2), umfassend eine Lichtquelle (3) zur Erzeugung von Licht, wobei das SMD-Bauteil (2) eine lichtemittierende Oberseite (2a), an welcher die Lichtquelle (3) angeordnet ist, und eine der lichtemittierenden Oberseite (2a) abgewandte Unterseite (2b) aufweist, und
* einen Schaltungsträger (4), wobei das SMD-Bauteil (2) an einem Bestückungsabschnitt (4a) des Schaltungsträgers (4) mit dem Schaltungsträger (4) mittels einer Lötverbindung wärmeleitend und/oder elektrisch leitend verbunden ist, wobei die Lötverbindung eine Lötschicht (9) umfasst, welche Lötgut aufweist, wobei die Lötschicht (9) zwischen der Unterseite (2b) des SMD-Bauteils (2) und dem Bestückungsabschnitt (4a) des Schaltungsträgers (4) angeordnet ist und das SMD-Bauteil (2) mit dem Schaltungsträger (4) verbindet, wobei
der Bestückungsabschnitt (4a) des Schaltungsträgers (4) eine Vielzahl von in einem Raster angeordneten und zueinander beabstandeten Kontakt-Elementen (5a) aufweist, welche sich von einer, vorzugsweise ebenen, Grundfläche (4b) des Schaltungsträgers (4) in Richtung des SMD-Bauteils (2) erstrecken und eine dem SMD-Bauteil (2) abgewandte Seite der Lötschicht (9) kontaktieren, wobei zwischen benachbarten Kontakt-Elementen (5a) Gasaustrittskanal-Abschnitte (6a) gebildet sind, wobei die Kontakt-Elemente (5a) derart zueinander angeordnet sind, dass die Gasaustrittskanal-Abschnitte (6a) ein zusammenhängendes Gasaustrittskanal-System (6) ausbilden, sodass jedes Kontakt-Element (5a) von einem Abschnitt des zusammenhängenden Gasaustrittskanal-Systems (6) umrandet ist, wobei die Gasaustrittskanal-Abschnitte (6a) von Seitenflächen benachbarter Kontakt-Elemente (5a), der Grundfläche (4b) und der dem SMD-Bauteil (2) abgewandten Seite der Lötschicht (9) begrenzt sind, wobei das Gasaustrittskanal-System (6) derart ausgestaltet und dazu eingerichtet ist, Gase, welche beim Lötprozess aus der Lötschicht (9) entweichen, über das Gasaustrittskanal-System (6) aus einem zwischen der Lötschicht (9) und der Grundfläche (4a) des Schaltungsträgers (4) ausgebildeten Volumen entweichen zu lassen,
wobei zur Wärmeabfuhr von Abwärme des SMD-Bauteils (2) der Schaltungsträger (4) eine Vielzahl von zur Wärmeleitung eingerichtete Mikro-Vias (7) aufweist, wobei die Wärmeleitung im Wesentlichen entlang einer Längserstreckung der Mikro-Vias (7) erfolgt, wobei die Mikro-Vias (7) in dem Schaltungsträger (4) derart angeordnet sind, dass sich die Mikro-Vias (7) zumindest abschnittsweise durch den Schaltungsträger (4) hin zum Bestückungsabschnitt (4a) erstrecken und die Vielzahl von Kontakt-Elementen (5a) durchsetzen, sodass die Mikro-Vias die Lötschicht (9) an einem Kontaktbereich der Lötschicht (9) zur Wärmeabfuhr kontaktieren, wobei die Mikro-Vias (7) an dem Kontaktbereich einen im Wesentlichen kreisförmigen Querschnitt aufweisen,
wobei eine Anzahl von Kontakt-Elementen (5a) eine im Wesentlichen hexagonale Grundfläche (5b) aufweisen, wobei die Grundflächen (5b) in einer Ebene liegen, welche im Wesentlichen parallel zur Grundfläche (4b) des Schaltungsträgers, und vorzugsweise parallel zur Unterseite (2b) des SMD-Bauteils (2), orientiert ist, wobei
die Mikro-Vias (7) in einer zweidimensionalen hexagonalen Packungsanordnung derart zueinander angeordnet sind, dass die im Wesentlichen hexagonalen Grundflächen (5b) der Kontakt-Elemente (5a) von einer Vielzahl von Mikro-Vias (7) im Wesentlichen vollständig, gemäß der höchsten Flächenpackungsdichte, durchsetzt sind.

2. Leuchtmittel (1) nach Anspruch 1, wobei benachbarte Mikro-Vias (7) an der hexagonalen Grundfläche (5b) eines Kontakt-Elements (5a) im Wesentlichen unmittelbar aneinander angrenzend zueinander angeordnet sind, wobei vorzugsweise die Vielzahl von Mikro-Vias (7) an dem Kontaktbereich einen im Wesentlichen gleich großen Durchmesser aufweisen.

3. Leuchtmittel (1) nach einem der vorhergehenden Ansprüche, wobei die Mikro-Vias (7) an dem Kontaktbereich einen Lochinnendurchmesser (d) aufweisen, welcher vorzugsweise < 0,5 mm, bevorzugt < 0,25 mm, besonders bevorzugt < 0,15 mm, beträgt.

4. Leuchtmittel (1) nach einem der vorhergehenden Ansprüche, wobei die Mikro-Vias (7) entlang ihrer Längserstreckung im Wesentlichen kegelförmig oder kegelstumpfförmig ausgestaltet sind, wobei vorzugsweise die Mikro-Vias (7) derart ausgestaltet sind, dass sich ein Kegeldurchmesser oder ein Kegelstumpfdurchmesser zur Lötschicht (9) hin verkleinert, wobei insbesondere ein Winkel zwischen einer Kegelachse oder einer Kegelstumpfachse und einer Mantelfläche des Kegels oder des Kegelstumpfs 6° bis 15° beträgt.

5. Leuchtmittel (1) nach einem der vorhergehenden Ansprüche, wobei die Mikro-Vias (7) in dem Schaltungsträger (4) derart angeordnet sind, dass jene Bereiche des Bestückungsabschnitts (4a), welche das Gasaustrittskanal-System (6) aufweisen, frei von Mikro-Vias (7) sind.

6. Leuchtmittel (1) nach einem der vorhergehenden Ansprüche, wobei der Schaltungsträger (4) eine dem SMD-Bauteil (2) zugewandte Außenfläche aufweist, an welcher der Bestückungsabschnitt (4a) ausgebildet ist, wobei der Schaltungsträger (4) eine Lötstopplackschicht aufweist, welche zumindest teilweise, vorzugsweise vollständig, um den Bestückungsabschnitt (4a) herum an der Außenfläche angeordnet ist.

7. Leuchtmittel (1) nach einem der vorhergehenden Ansprüche, wobei die Kontakt-Elemente (5a) mit einem wärmeleitenden und/oder elektrisch leitenden Material, insbesondere mit einem Metall, beispielsweise Kupfer, beschichtet sind oder aus einem wärmeleitenden und/oder elektrisch leitenden Material ausgebildet sind.

8. Leuchtmittel (1) nach einem der vorhergehenden Ansprüche, wobei der Schaltungsträger (4) als eine mehrschichtige Leiterplatte ausgestaltet ist, welche ein Metall-Inlay (8), vorzugsweise ein Kupfer-Inlay, aufweist, wobei die Mirco-Vias (7) mit dem Metall-Inlay (8) wärmeleitend verbunden sind.

9. Leuchtmittel (1) nach einem der vorhergehenden Ansprüche, wobei die hexagonalen Kontakt-Elemente (5a) Polyeder ausbilden, welche eine im Wesentlichen gleich große hexagonale Grundfläche (5b) aufweisen.

10. Leuchtmittel (1) nach einem der vorhergehenden Ansprüche, wobei die Grundflächen (5b) der hexagonalen Kontakt-Elemente (5a) jeweils ein regelmäßiges Hexagon ausbilden.

11. Leuchtmittel (1) nach einem der vorhergehenden Ansprüche, wobei jeder Gasaustrittskanal-Abschnitt (6a) des Gasaustrittskanal-Systems (6) eine Kanalbreite aufweist, welche als ein Normalabstand zwischen parallelen Seitenkanten von zwei benachbarten Kontakt-Elementen (5a) definiert ist, wobei das Gasaustrittskanal-System (6) derart ausgestaltet ist, dass alle Gasaustrittskanal-Abschnitte (6a) im Wesentlichen die gleiche Kanalbreite aufweisen.

12. Leuchtmittel (1) nach einem der vorhergehenden Ansprüche, wobei jeder Gasaustrittskanal-Abschnitt (6a) des Gasaustrittskanal-Systems (6) eine Kanalhöhe aufweist, welche einem Normalabstand zwischen der Grundfläche (4b) des Schaltungsträgers (4) und der dem SMD-Bauteil (2) abgewandten Seite der Lötschicht (9) entspricht, wobei vorzugsweise die Kanalhöhe des Gasaustrittskanal-Systems (6) über den gesamten Bestückungsabschnitt (4a) konstant ist, wobei vorzugsweise die Kanalhöhe 100-200 µm beträgt.

13. Leuchtmittel (1) nach einem der vorhergehenden Ansprüche, wobei der Bestückungsabschnitt (4a) des Schaltungsträgers (4) eine größere Fläche aufweist als die Unterseite (2b) des SMD-Bauteils.

14. Leuchtmittel (1) nach einem der vorhergehenden Ansprüche, wobei von der Vielzahl von in einem Raster angeordneten Kontakt-Elementen (5a) zumindest 50%, vorzugsweise mehr als 75%, bevorzugt mehr als 85%, besonders bevorzugt mehr als 95% der Kontakt-Elemente (5a) eine hexagonale Grundfläche (5b) aufweisen.

15. Kraftfahrzeugscheinwerfer, umfassend ein Leuchtmittel (1) nach einem der vorhergehenden Ansprüche.

## Claims

1. Illuminant (1) for a motor vehicle headlight, the illuminant (1) comprising the following:
* an SMD component (2), comprising a light source (3) for generating light, the SMD component (2) having a light-emitting top side (2a), on which the light source (3) is arranged, and an underside (2b) facing away from the light-emitting top side (2a), and
* a circuit carrier (4), wherein the SMD component (2) is connected to the circuit carrier (4) in a thermally conductive and/or electrically conductive manner at a mounting section (4a) of the circuit carrier (4) by means of a solder connection, wherein the solder connection comprises a solder layer (9), which has solder, the solder layer (9) being arranged between the underside (2b) of the SMD component (2) and the mounting section (4a) of the circuit carrier (4) and connecting the SMD component (2) to the circuit carrier (4),
wherein
the mounting section (4a) of the circuit carrier (4) has a plurality of contact elements (5a) arranged in a grid and spaced apart from one another, which extend from a, preferably flat, base surface (4b) of the circuit carrier (4) in the direction of the SMD component (2) and contact a side of the solder layer (9) facing away from the SMD component (2), wherein gas outlet channel sections (6a) are formed between adjacent contact elements (5a), wherein the contact elements (5a) are arranged relative to one another in such a way that the gas outlet channel sections (6a) form a continuous gas outlet channel system (6), so that each contact element (5a) is surrounded by a section of the continuous gas outlet channel system (6), wherein the gas outlet channel sections (6a) are bounded by side surfaces of neighboring contact elements (5a), the base surface (4b) and the side of the solder layer (9) facing away from the SMD component (2), wherein the gas outlet channel system (6) is designed and set up to allow gases which escape from the solder layer (9) during the soldering process to escape via the gas outlet channel system (6), from a volume formed between the solder layer (9) and the base surface (4a) of the circuit carrier (4) via the gas outlet channel system (6),
wherein for heat dissipation of waste heat from the SMD component (2), the circuit carrier (4) has a plurality of micro-vias (7) set up for heat conduction, wherein the heat conduction takes place essentially along a longitudinal extension of the micro-vias (7), wherein the micro-vias (7) are arranged in the circuit carrier (4) in such a way that the micro-vias (7) extend at least in sections through the circuit carrier (4) towards the mounting section (4a) and pass through the plurality of contact elements (5a), so that the micro-vias contact the solder layer (9) at a contact region of the solder layer (9) for heat dissipation, wherein the micro-vias (7) have a substantially circular cross-section at the contact region,
wherein
a number of contact elements (5a) have a substantially hexagonal base area (5b), wherein the base areas (5b) lie in a plane which is oriented substantially parallel to the base surface (4b) of the circuit carrier and preferably parallel to the underside (2b) of the SMD component (2), wherein
the micro-vias (7) are arranged in a two-dimensional hexagonal packing arrangement in such a way that the substantially hexagonal base areas (5b) of the contact elements (5a) are substantially completely interspersed by a plurality of micro-vias (7) in accordance with the highest surface packing density.

2. Illuminant (1) according to claim 1, wherein adjacent micro-vias (7) on the hexagonal base area (5b) of a contact element (5a) are arranged substantially directly adjacent to each other, wherein preferably the plurality of micro-vias (7) at the contact area have a substantially equal diameter.

3. Illuminant (1) according to any of the preceding claims, wherein the micro-vias (7) at the contact area have an inner hole diameter (d) which is preferably < 0.5 mm, preferably < 0.25 mm, particularly preferably < 0.15 mm.

4. Illuminant (1) according to any of the preceding claims, wherein the micro-vias (7) are essentially conical or frustoconical along their longitudinal extension, wherein preferably the micro-vias (7) are designed in such a way that a cone diameter or a frustoconical diameter decreases towards the solder layer (9), wherein in particular an angle between a cone axis or a frustoconical axis and a lateral surface of the cone or the frustoconical axis is 6° to 15°.

5. Illuminant (1) according to any of the preceding claims, wherein the micro-vias (7) are arranged in the circuit carrier (4) in such a way that those regions of the mounting section (4a) which have the gas outlet channel system (6) are free of micro-vias (7).

6. Illuminant (1) according to any of the preceding claims, wherein the circuit carrier (4) has an outer surface facing the SMD component (2), on which the mounting section (4a) is formed, wherein the circuit carrier (4) has a solder resist layer which is arranged at least partially, preferably completely, around the mounting section (4a) on the outer surface.

7. Illuminant (1) according to any of the preceding claims, wherein the contact elements (5a) are coated with a thermally conductive and/or electrically conductive material, in particular with a metal, for example copper, or are formed from a thermally conductive and/or electrically conductive material.

8. Illuminant (1) according to any of the preceding claims, wherein the circuit carrier (4) is designed as a multilayer printed circuit board which has a metal inlay (8), preferably a copper inlay, wherein the micro vias (7) are connected to the metal inlay (8) in a thermally conductive manner.

9. Illuminant (1) according to any of the preceding claims, wherein the hexagonal contact elements (5a) form polyhedra which have a hexagonal base area (5b) of substantially the same size.

10. Illuminant (1) according to any of the preceding claims, wherein the base areas (5b) of the hexagonal contact elements (5a) each form a regular hexagon.

11. Illuminant (1) according to any of the preceding claims, wherein each gas outlet channel section (6a) of the gas outlet channel system (6) has a channel width which is defined as a normal distance between parallel side edges of two adjacent contact elements (5a), wherein the gas outlet channel system (6) is designed in such a way that all gas outlet channel sections (6a) have substantially the same channel width.

12. Illuminant (1) according to any of the preceding claims, wherein each gas outlet channel section (6a) of the gas outlet channel system (6) has a channel height which corresponds to a normal distance between the base surface (4b) of the circuit carrier (4) and the side of the solder layer (9) facing away from the SMD component (2), wherein preferably the channel height of the gas outlet channel system (6) is constant over the entire mounting section (4a), wherein preferably the channel height is 100-200 µm.

13. Illuminant (1) according to any of the preceding claims, wherein the mounting section (4a) of the circuit carrier (4) has a larger area than the underside (2b) of the SMD component.

14. Illuminant (1) according to any of the preceding claims, wherein of the plurality of contact elements (5a) arranged in a grid, at least 50%, preferably more than 75%, preferably more than 85%, particularly preferably more than 95% of the contact elements (5a) have a hexagonal base area (5b).

15. Motor vehicle headlamp, comprising an illuminant (1) according to any of the preceding claims.

## Revendications

1. Moyen d'éclairage (1) pour un phare de véhicule automobile, le moyen d'éclairage (1) comprenant :
* un composant CMS (2), comprenant une source lumineuse (3) pour produire de la lumière, le composant CMS (2) présentant une face supérieure émettrice de lumière (2a), sur laquelle est disposée la source lumineuse (3), et une face inférieure (2b) opposée à la face supérieure émettrice de lumière (2a), et
* un support de circuit (4), le composant CMS (2) étant relié à une section d'équipement (4a) du support de circuit (4) avec le support de circuit (4) au moyen d'une liaison par brasage de manière à conduire la chaleur et/ou à conduire l'électricité, la liaison par brasage comprenant une couche de brasage (9), qui présente de la soudure, la couche de brasage (9) étant disposée entre la face inférieure (2b) du composant CMS (2) et la section d'équipement (4a) du support de circuit (4) et reliant le composant CMS (2) au support de circuit (4),
dans lequel
la section d'équipement (4a) du support de circuit (4) présente une pluralité d'éléments de contact (5a) disposés selon une trame et espacés les uns des autres, qui s'étendent depuis une surface de base (4b), de préférence plane, du support de circuit (4) en direction du composant CMS (2) et qui sont en contact avec une face de la couche de brasage (9) opposée au composant CMS (2), des sections de canal de sortie de gaz (6a) étant formées entre des éléments de contact (5a) voisins, les éléments de contact (5a) étant disposés les uns par rapport aux autres de telle sorte que les sections de canal de sortie de gaz (6a) forment un système de canaux de sortie de gaz (6) cohérent, de sorte que chaque élément de contact (5a) est bordé par une section du système de canaux de sortie de gaz (6) cohérent, les sections de canal de sortie de gaz (6a) étant délimitées par des surfaces latérales d'éléments de contact (5a) voisins, la surface de base (4b) et le côté de la couche de brasage (9) opposé au composant CMS (2), le système de canaux de sortie de gaz (6) étant conçu et agencé de manière à évacuer les gaz qui s'échappent de la couche de brasage (9) lors du processus de brasage, par le système de canaux de sortie de gaz (6) d'un volume formé entre la couche de brasage (9) et la surface de base (4a) du support de circuit (4),
dans lequel, pour l'évacuation de la chaleur dissipée par le composant CMS (2), le support de circuit (4) présente une pluralité de micro-vias (7) aménagées pour la conduction thermique, la conduction thermique s'effectuant essentiellement le long d'une extension longitudinale des micro-vias (7), les micro-vias (7) étant disposés dans le support de circuit (4) de telle sorte, que les micro-vias (7) s'étendent au moins par sections à travers le support de circuit (4) vers la section d'équipement (4a) et traversent la pluralité d'éléments de contact (5a), de sorte que les micro-vias entrent en contact avec la couche de brasage (9) au niveau d'une zone de contact de la couche de brasage (9) pour la dissipation de chaleur, les micro-vias (7) présentant une section transversale sensiblement circulaire au niveau de la zone de contact,
dans lequel
un certain nombre d'éléments de contact (5a) présentent une surface de base (5b) sensiblement hexagonale, les surfaces de base (5b) étant situées dans un plan qui est orienté sensiblement parallèlement à la surface de base (4b) du support de circuit, et de préférence parallèlement à la face inférieure (2b) du composant CMS (2), les micro-vias (7) étant
disposés les uns par rapport aux autres dans un agencement d'empilement hexagonal bidimensionnel de telle sorte que les surfaces de base (5b) sensiblement hexagonales des éléments de contact (5a) soient traversées par une pluralité de micro-vias (7) sensiblement complètement, selon la densité d'empilement de surface la plus élevée.

2. Moyen d'éclairage (1) selon la revendication 1, dans lequel des micro-vias (7) adjacents sont disposés sur la surface de base hexagonale (5b) d'un élément de contact (5a) sensiblement directement adjacents les uns aux autres, de préférence la pluralité de micro-vias (7) sur la zone de contact ayant un diamètre sensiblement égal.

3. Moyen d'éclairage (1) selon l'une des revendications précédentes, dans lequel les micro-vias (7) présentent un diamètre intérieur de trou (d) sur la zone de contact, qui est de préférence < 0,5 mm, de préférence < 0,25 mm, de manière particulièrement préférée < 0,15 mm.

4. Moyen d'éclairage (1) selon l'une des revendications précédentes, dans lequel les micro-vias (7) ont une forme essentiellement conique ou tronconique le long de leur extension longitudinale, les micro-vias (7) étant de préférence conçus de telle sorte qu'un diamètre de cône ou un diamètre de cône tronqué diminue en direction de la couche de brasage (9), un angle entre un axe de cône ou un axe de cône tronqué et une surface d'enveloppe du cône ou du cône tronqué étant notamment de 6° à 15°.

5. Moyen d'éclairage (1) selon l'une des revendications précédentes, dans lequel les micro-vias (7) sont disposés dans le support de circuit (4) de telle sorte que les zones de la section d'équipement (4a) qui présentent le système de canaux de sortie de gaz (6) sont exemptes de micro-vias (7).

6. Moyen d'éclairage (1) selon l'une des revendications précédentes, dans lequel le support de circuit (4) présente une surface extérieure tournée vers le composant CMS (2), sur laquelle est formée la section d'équipement (4a), le support de circuit (4) présentant une couche de vernis épargne qui est disposée au moins partiellement, de préférence entièrement, autour de la section d'équipement (4a) sur la surface extérieure.

7. Moyen d'éclairage (1) selon l'une des revendications précédentes, dans lequel les éléments de contact (5a) sont revêtus d'un matériau conducteur de la chaleur et/ou de l'électricité, notamment d'un métal, par exemple du cuivre, ou sont formés d'un matériau conducteur de la chaleur et/ou de l'électricité.

8. Moyen d'éclairage (1) selon l'une des revendications précédentes, dans lequel le support de circuit (4) est conçu comme une carte de circuit imprimé multicouche, qui présente un inlay métallique (8), de préférence un inlay en cuivre, les micro-vias (7) étant reliés à l'inlay métallique (8) de manière à conduire la chaleur.

9. Moyen d'éclairage (1) selon l'une des revendications précédentes, dans lequel les éléments de contact hexagonaux (5a) forment des polyèdres qui présentent une surface de base hexagonale (5b) de taille sensiblement égale.

10. Moyen d'éclairage (1) selon l'une des revendications précédentes, dans lequel les surfaces de base (5b) des éléments de contact hexagonaux (5a) forment chacune un hexagone régulier.

11. Moyen d'éclairage (1) selon l'une des revendications précédentes, dans lequel chaque section de canal de sortie de gaz (6a) du système de canaux de sortie de gaz (6) présente une largeur de canal qui est définie comme une distance normale entre des bords latéraux parallèles de deux éléments de contact (5a) adjacents, le système de canaux de sortie de gaz (6) étant configuré de telle sorte que toutes les sections de canaux de sortie de gaz (6a) présentent sensiblement la même largeur de canal.

12. Moyen d'éclairage (1) selon l'une des revendications précédentes, dans lequel chaque section de canal de sortie de gaz (6a) du système de canaux de sortie de gaz (6) présente une hauteur de canal qui correspond à une distance normale entre la surface de base (4b) du support de circuit (4) et le côté de la couche de brasage (9) opposé au composant CMS (2), la hauteur de canal du système de canaux de sortie de gaz (6) étant de préférence constante sur toute la section d'équipement (4a), la hauteur de canal étant de préférence de 100-200 µm.

13. Moyen d'éclairage (1) selon l'une des revendications précédentes, dans lequel la section d'équipement (4a) du support de circuit (4) présente une surface plus grande que la face inférieure (2b) du composant CMS.

14. Moyen d'éclairage (1) selon l'une des revendications précédentes, dans lequel, parmi la pluralité d'éléments de contact (5a) disposés selon un quadrillage, au moins 50%, de préférence plus de 75%, de préférence plus de 85%, de manière particulièrement préférée plus de 95% des éléments de contact (5a) présentent une surface de base hexagonale (5b).

15. Projecteur de véhicule automobile, comprenant un moyen d'éclairage (1) selon l'une quelconque des revendications précédentes.
